(19) Europäisches Patentamt
European Patent Office
Office européen des brevets

(11) **EP 3 215 903 B1**

(12) **FASCICULE DE BREVET EUROPEEN**

(45) Date de publication et mention
de la délivrance du brevet:
**18.12.2019 Bulletin 2019/51**

(21) Numéro de dépôt: **15798515.1**

(22) Date de dépôt: **28.10.2015**

(51) Int Cl.:
*G05B 23/02* *(2006.01)*  *B64D 45/00* *(2006.01)*
*F01D 17/02* *(2006.01)*  *G07C 5/08* *(2006.01)*
*B64F 5/60* *(2017.01)*  *F01D 21/00* *(2006.01)*

(86) Numéro de dépôt international:
**PCT/FR2015/052905**

(87) Numéro de publication internationale:
**WO 2016/071605 (12.05.2016 Gazette 2016/19)**

(54) **OUTIL DE VALIDATION D'UN SYSTÈME DE SURVEILLANCE D'UN MOTEUR D'AÉRONEF**

WERKZEUG ZUR VALIDIERUNG EINES SYSTEMS ZUR ÜBERWACHUNG EINES FLUGZEUGTRIEBWERKS

TOOL FOR VALIDATING A SYSTEM FOR MONITORING AN AIRCRAFT ENGINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.11.2014 FR 1460668**

(43) Date de publication de la demande:
**13.09.2017 Bulletin 2017/37**

(73) Titulaire: **SAFRAN AIRCRAFT ENGINES**
**75015 Paris (FR)**

(72) Inventeur: **LACAILLE, Jérôme, Henri, Noël**
**77550 Moissy-Cramayel Cedex (FR)**

(74) Mandataire: **Brevalex**
**56, Boulevard de l'Embouchure**
**B.P. 27519**
**31075 Toulouse Cedex 2 (FR)**

(56) Documents cités:
**WO-A1-2013/171427    FR-A1- 2 957 170**

**Description**

**DOMAINE TECHNIQUE**

La présente invention concerne le domaine de systèmes de surveillance d'un moteur d'un aéronef et plus particulièrement, d'un outil de validation d'un système de surveillance d'un équipement du moteur d'aéronef.

**ÉTAT DE LA TECHNIQUE ANTÉRIEURE**

Les systèmes de surveillance sont utilisés pour vérifier le bon fonctionnement des différents équipements du moteur d'aéronef. Il existe par exemple, un système de surveillance pour analyser le comportement du moteur pendant le processus d'allumage, un autre pour analyser la trajectoire des gaz, un autre encore pour détecter le colmatage des filtres, et un autre pour analyser la consommation d'huile, etc.

Tous ces systèmes de surveillance permettent d'améliorer la sécurité et la fiabilité des moteurs d'aéronef. En particulier, ils permettent d'éviter ou de limiter l'arrêt en vol, de réduire les retards ou annulation des vols, et plus particulièrement, facilitent la maintenance du moteur en anticipant les défaillances et en identifiant les composants fautifs ou défaillants.

Actuellement, il existe un outil de conception d'un système de surveillance basé sur des indicateurs que l'on compare à des seuils définis par des spécifications. Cet outil est décrit dans la demande de brevet français FR2957170 de la Demanderesse.

La validation d'un système de surveillance nécessite de réaliser des tests par exemple sur un banc d'essais afin de recueillir un grand nombre de données. Il faut alors déployer beaucoup de ressources et de temps pour réaliser ces tests et de plus, le grand nombre de données recueillies peuvent réclamer un important temps de calcul.

En outre, il peut arriver que le niveau de validation d'un système de surveillance soit différent de celui d'un autre système de surveillance. Ceci peut compliquer l'analyse des données issues des différents systèmes de surveillance du moteur.

L'objet de la présente invention est de proposer un outil de validation d'un système de surveillance d'un équipement du moteur d'aéronef permettant d'optimiser la quantité de données nécessaires pour la validation réduisant ainsi les coûts et le temps de développement tout en augmentant la fiabilité du système de surveillance.

**EXPOSÉ DE L'INVENTION**

La présente invention est définie par un outil de validation d'un système de surveillance d'au moins un équipement d'un moteur d'aéronef, comportant :

- des moyens de traitement configurés pour recueillir des données d'observation relatives audit équipement,
- des moyens d'analyse configurés pour calculer une valeur courante d'au moins un indicateur de qualité sur une quantité courante de données d'observation recueillies par les moyens de traitement,
- des moyens d'analyse configurés pour estimer la probabilité que ladite valeur courante de l'indicateur de qualité atteigne un critère de fiabilité prédéterminé, formant ainsi une loi probabiliste de fiabilité estimée sur un ensemble de valeurs de l'indicateur de qualité relatif à un ensemble correspondant de quantités de données d'observation, et
- des moyens d'analyse configurés pour estimer à partir de ladite loi probabiliste de fiabilité une quantité minimale de données d'observation à partir de laquelle la valeur de l'indicateur de qualité atteint un critère de fiabilité prédéterminé avec une probabilité supérieure à une valeur prédéterminée,
- des moyens de test configurés pour évaluer une validation dudit système de surveillance en appliquant un ensemble d'indicateurs de qualité sur ladite quantité minimale de données d'observation relatives audit équipement.

Ceci permet de savoir quand est ce qu'il faut s'arrêter de collecter des données pour l'évaluation du système de surveillance et permet donc de réduire les coûts des essais.

Avantageusement, ladite valeur prédéterminée est le complémentaire d'une erreur prédéfinie comme étant acceptable.

Avantageusement, les moyens d'analyse sont configurés pour calculer la valeur courante d'un indicateur de qualité en appliquant une technique de validation croisée sur ladite quantité courante de données d'observation. Ladite technique de validation croisée peut être sélectionnée parmi les techniques suivantes : bootstrap, K-fold, leave-one-out.

Avantageusement, l'ensemble d'indicateurs de qualité comporte les indicateurs suivants : taux de fausse alarme, taux de détection, taux de localisation.

Avantageusement, les moyens d'analyse sont configurés pour appliquer une technique de régression sur ledit ensemble de valeurs de l'indicateur de qualité pour déterminer une fonction d'approximation représentative de ladite loi probabiliste de fiabilité en fonction de la quantité de données d'observation.

Selon une particularité de la présente invention, pour un indicateur de qualité correspondant aux taux de fausse alarme, ladite fonction d'approximation en fonction de la quantité n de données d'observation est exprimée par la relation suivante :

$$f(n) = a + \frac{b}{\sqrt{n}} + c \log(n)$$

où *a, b, c* sont des constantes de régression.

Avantageusement, les moyens de test sont configurés pour évaluer une validation dudit système de surveillance avant son installation sur un aéronef en appliquant l'ensemble d'indicateurs de qualité sur une quantité de données d'observation recueillies sur un banc d'essai et/ou sur une flotte de moteurs d'aéronefs en opération. Ceci permet de valider un système de surveillance générique adapté pour surveiller un moteur de série.

Avantageusement, les moyens de test sont configurés pour poursuivre la validation et le réglage dudit système de surveillance après son installation sur un moteur de série en appliquant l'ensemble d'indicateurs de qualité sur une quantité de données d'observation recueillies en vol. Ceci permet de spécialiser le système de surveillance pour qu'il soit adapté à la spécificité de l'utilisation du moteur sur lequel il est installé sachant que le comportement du moteur peut dépendre des missions, des trajets, de la maintenance, etc.

L'invention vise également un système de surveillance d'au moins un équipement d'un moteur d'aéronef conçu par l'outil de validation selon l'une quelconque des caractéristiques précédentes, ledit système étant configuré pour recevoir des données d'observation spécifiques audit équipement et pour délivrer un résultat diagnostiquant l'état dudit équipement.

L'invention vise aussi un procédé de validation d'un système de surveillance d'au moins un équipement d'un moteur d'aéronef, comprenant des étapes de test pour évaluer une validation dudit système de surveillance en appliquant un ensemble d'indicateurs de qualité sur un volume de données d'observation relatives audit équipement, ledit procédé comportant en outre les étapes suivantes :

- recueillir des données d'observation relatives audit équipement,
- calculer une valeur courante d'au moins un indicateur de qualité sur une quantité courante de données d'observation recueillies par les moyens de traitement,
- estimer la probabilité que ladite valeur courante de l'indicateur de qualité atteigne un critère de fiabilité prédéterminé, formant ainsi une loi probabiliste de fiabilité estimée sur un ensemble de valeurs de l'indicateur de qualité relatif à un ensemble correspondant de quantités de données d'observation, et
- estimer à partir de ladite loi probabiliste de fiabilité une quantité minimale de données d'observation à partir de laquelle la valeur de l'indicateur de qualité atteigne un critère de fiabilité prédéterminé avec une probabilité supérieure à une valeur prédéterminée, ladite quantité minimale de données d'observation correspondant audit volume de données d'observation destiné à être utilisé pour évaluer la validation dudit système de surveillance.

**BRÈVE DESCRIPTION DES DESSINS**

D'autres particularités et avantages de l'outil et du procédé selon l'invention ressortiront mieux à la lecture de la description faite ci-après, à titre indicatif mais non limitatif, en référence aux dessins annexés sur lesquels :

- la Fig. 1 illustre de manière schématique un outil de validation d'un système de surveillance d'un équipement d'un moteur d'aéronef, selon un mode de réalisation de l'invention ;
- la Fig. 2 est un organigramme illustrant un procédé de détermination d'un nombre minimal de données d'observation et de validation d'un système de surveillance d'au moins un équipement d'un moteur d'aéronef, selon un mode de réalisation de l'invention ;
- la Fig. 3 est un graphique représentant des courbes relatives à une loi théorique de fiabilité et à sa fonction d'approximation, selon l'invention ;
- la Fig. 4 est un graphique représentant des mesures d'observation autour de la courbe relative à la loi théorique de fiabilité ;
- la Fig. 5 illustre de manière schématique un outil de validation d'un système de surveillance d'un équipement d'un moteur d'aéronef, selon un premier mode de réalisation préféré de l'invention ; et
- la Fig. 6 illustre de manière schématique un outil de validation d'un système de surveillance d'un équipement d'un moteur d'aéronef, selon un deuxième mode de réalisation préféré de l'invention.

**EXPOSÉ DÉTAILLÉ DE MODES DE RÉALISATION PARTICULIERS**

La présente invention propose de mettre en œuvre un outil permettant d'estimer et d'anticiper la quantité de données nécessaire pour réaliser la validation d'un système de surveillance.

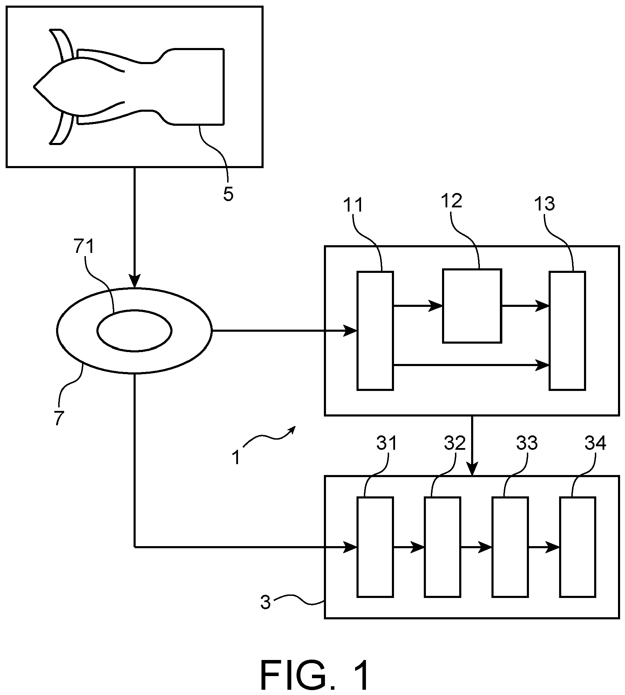

La Fig. 1 illustre de manière schématique un outil de validation 1 d'un système de surveillance 3 d'un équipement d'un moteur 5 d'aéronef, selon un mode de réalisation préféré de l'invention.

Le système de surveillance 3 peut être composé de modules 31-34 et chaque module réalise une tâche particulière en utilisant un algorithme spécifique. Un tel système de surveillance est décrit dans la demande de brevet FR2957170 de la demanderesse et peut comporter un module d'acquisition 31 de données, un module de normalisation 32, un module de diagnostic ou de détection d'anomalie 33, un module de classification 34 pour identifier les fautes, etc.

En exécution, le module d'acquisition 31 de données est configuré pour recevoir des mesures ou données spécifiques 71 acquises par des capteurs sur le moteur 5 d'aéronef ou par un calculateur embarqué et pour délivrer des données ou variables spécifiques donnant des indications sur des éléments physiques ou logiques de l'équipement du moteur 5. Ces données 71 sont extraites des mesures brutes temporelles (températures, pressions, débit du carburant, rotations d'arbres, etc.).

A titre d'exemple, les données spécifiques peuvent correspondre au délai nécessaire pour qu'un arbre du moteur atteigne l'accélération maximale après chaque démarrage du moteur, le gradient des températures des gaz d'échappement du moteur, le temps d'allumage, le temps d'ouverture de soupape, la tendance de la vitesse, etc.

Le module de normalisation 32 est configuré pour recevoir les données spécifiques en provenance du module d'acquisition 31 pour normaliser ces données spécifiques et pour délivrer des données standardisées indépendantes vis-à-vis du contexte.

A partir de ces données standardisées, il s'agit maintenant de diagnostiquer une anomalie puis de déduire une défaillance spécifique et éventuellement le composant physique concerné.

Ainsi, le module de détection d'anomalie 33 est configuré pour recevoir les données standardisées en provenance du module de normalisation 32 pour construire une signature représentative du comportement du moteur 5 et pour diagnostiquer si la signature révèle une anomalie. En outre, le module de détection d'anomalie 33 est configuré pour délivrer un score représentatif de la signature. Selon la valeur du score par rapport à un seuil prédéfini, le module de détection 33 est configuré pour générer ou pas une alarme indiquant qu'une anomalie est détectée.

Le module de classification 34 est configuré pour délivrer une mesure d'identification des défaillances. Après avoir identifié les défaillances en calculant par exemple, pour chacune une probabilité d'occurrence, le système de surveillance 3 peut utiliser cette dernière pour détecter les composants fautifs.

Ainsi, selon le type d'application, le système de surveillance 3 est configuré pour réaliser plusieurs tâches pouvant comprendre l'acquisition des données, la normalisation des données, la détection d'anomalies, et éventuellement la classification des anomalies détectées.

Toutefois, le système de surveillance 3 doit subir une phase de qualification ou de validation avant qu'il soit mis en opération.

L'outil de validation est donc utilisé pour vérifier la validation du système de surveillance. Conformément à l'invention, l'outil de validation 1 comporte des moyens de traitement 11, des moyens d'analyse 12 et des moyens de test 13. Ces moyens 11-13 sont mis en œuvre par des dispositifs que l'on trouve habituellement dans un ordinateur : une unité centrale de traitement et de calcul, des moyens de stockage, des périphériques d'entrées ainsi que des périphériques de sorties.

Les moyens de traitement 11 sont configurés pour recueillir des données d'observation 7 relatives à l'équipement du moteur 5 à surveiller. Ces données d'observation 7 comportent des mesures spécifiques 71 acquises par les capteurs sur le moteur 5 d'aéronef ou par un calculateur embarqué, et destinées à être utilisées par le système de surveillance 3 pour détecter des fautes ou anomalies. Par ailleurs, les données d'observation 7 peuvent aussi comporter des données issues des tests réalisés sur un banc d'essai ou des enregistrements réalisés sur un moteur opérationnel ou éventuellement des données de simulation.

En outre, les moyens de test 13 sont configurés pour évaluer la validation du système de surveillance en appliquant un ensemble d'indicateurs de qualité KPI (Key Performance Indicators) sur un volume de données d'observation 7 relatives à cet équipement.

Plus particulièrement, les moyens de test 13 appliquent un indicateur ou plusieurs indicateurs de qualité KPI sur le résultat du système de surveillance 3 pour vérifier la détection des fautes. Ceci donne une note qui permet de valider le système de surveillance 3 sur le volume de données d'observation 7.

Avantageusement, l'ensemble d'indicateurs de qualité KPI comporte une mesure d'un taux de détection POD (Probability Of Détection), une mesure d'un taux de fausse alarme PFA (Probability of False Alarm), une mesure d'un taux de localisation PCL (Probability of Class Localisation), etc. On notera que chacun des indicateurs de qualité peut être utilisé indépendamment d'un autre indicateur ou en combinaison selon le type d'application du système de surveillance 3.

Le taux de détection POD, également appelé la puissance de détection, est la probabilité de détecter une faute quand l'équipement surveillé présente réellement une faute. Il peut être estimé comme le rapport du nombre de fautes détectées sur le nombre total de fautes. Ainsi, le taux de détection POD permet de valider avec une grande fiabilité le résultat du système de surveillance 3.

Le taux de fausse alarme PFA est défini comme étant la probabilité que l'équipement surveillé est sain quand le système de surveillance 3 détecte une faute. Le taux de fausse-alarme PFA peut être calculé à partir des règles bayésiennes. Soit *P(détecté)* la probabilité marginale qu'une anomalie soit détectée par le système de surveillance 3, et *P(sain)* la probabilité marginale que l'équipement est sain. Alors, le taux de fausse alarme PFA est la probabilité que l'équipement est a posteriori sain sachant qu'une faute est détectée.

Le taux de fausse-alarme PFA est un critère très important dans le domaine aéronautique. En effet, l'événement que l'équipement est sain lorsque le système de surveillance 3 détecte une faute est un phénomène qu'il faut limiter parce qu'il peut modifier de manière définitive l'image de crédibilité que l'utilisateur peut avoir du système de surveillance 3. Ainsi, il est très avantageux que le taux de fausse-alarme PFA soit faible.

L'indicateur de qualité de données est une mesure d'un taux de localisation PCL (Probability of Class Localisation) définie comme étant la probabilité qu'une localisation est bonne lorsqu'une anomalie de l'équipement est observée.

Le taux de localisation PCL, qui est une information de qualité de classification, permet de valider avec une grande efficacité le résultat du système de surveillance 3. Ceci permet de bien localiser l'élément précis (par exemple, alternateur, câble, harnais, etc.) de l'équipement présentant une anomalie.

D'une manière générale, le taux de détection POD permet de détecter si l'équipement comporte un élément anormal, et ensuite le taux de localisation PCL indique l'efficacité avec laquelle on peut localiser ou identifier cet élément.

Au moins une partie de l'ensemble d'indicateurs de qualité est appliquée sur les données d'observation 7 recueillies par les moyens de traitement 11 pour valider le système de surveillance 3.

Toutefois, la précision des indicateurs de qualité dépend de la quantité de données d'observation 7. Ainsi, il est avantageux de connaître à partir de quel nombre de données d'observation 7 la précision des indicateurs est convenable pour que des exigences de qualité prédéterminées soient satisfaites par ces indicateurs.

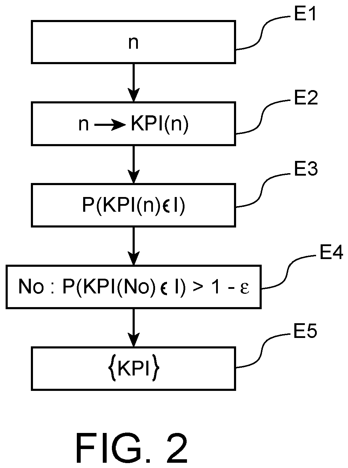

En effet, la Fig. 2 est un organigramme illustrant un procédé de détermination d'un nombre minimal de données d'observation et de validation d'un système de surveillance d'au moins un équipement d'un moteur d'aéronef, selon l'invention.

L'étape E1 concerne la collecte d'une quantité courante de données d'observation 7 par les moyens de traitement 11.

A l'étape E2, à chaque quantité courante (ou nombre courant) de données d'observation 7 recueillies par les moyens de traitement 11, les moyens d'analyse 12 sont configurés pour calculer une valeur courante d'au moins un indicateur de qualité.

Autrement dit, pour chaque nombre courant n de données d'observation 7, les moyens d'analyse 12 calculent la valeur courante KPI(n) d'un indicateur de qualité KPI.

Avantageusement, la valeur courante KPI(n) d'un indicateur de qualité est calculée en appliquant une technique de validation croisée sur la quantité courante n de données d'observation 7.

La technique de validation croisée peut être sélectionnée parmi les techniques suivantes : « bootstrap », « K-fold », et « leave-one-out ». Elle consiste à générer de nouveaux jeux de données issus du jeu principal de taille courante n. Pour chaque jeu de données, les moyens d'analyse 12 sont configurés pour réaliser une expérience i et pour calculer une valeur correspondante du KPI.

Plus particulièrement, le « bootstrap » consiste à tirer avec remise n observations pour le calibrage et calculer le KPI sur le jeu initial.

Le « K-fold » consiste à créer des jeux de données de calibrage par sélection d'une proportion prédéterminée de données d'observations et de tester sur le reste. Cette opération est répétée K fois.

Le « leave-one-out » calibre l'application sur n-1 données d'observation et la teste sur la dernière, on obtient n résultats élémentaires.

La validation croisée permet ainsi de générer une population de valeurs $X_i$ = *KPI(n|experience i)* obtenues pour chaque expérience. Cette population de valeurs $(X_i)_{i=1...K}$ donne une représentation empirique de la valeur courante *KPI(n)*.

A l'étape E3, les moyens d'analyse 12 sont configurés pour estimer une probabilité $P(KPI(n) \in I) = P(n)$ définie comme étant la probabilité que la valeur courante *KPI(n)* de l'indicateur de qualité KPI atteigne un critère de fiabilité prédéterminé, ce dernier correspondant à un intervalle *I* prédéterminé.

Ainsi, les moyens d'analyse 12 forment de manière itérative (i.e., pour n = $N_i$, ....,$N_m$), une loi probabiliste de fiabilité *P(n)* estimée sur un ensemble de valeurs courantes calculées des variables aléatoires $KPI(N_i)$, ...,$KPI(N_m)$ de l'indicateur de qualité relatif à un ensemble correspondant de quantités courantes $N_i$, ...., $N_m$ de données d'observation 7.

Avantageusement, les moyens d'analyse 12 sont configurés pour appliquer une technique de régression sur l'ensemble de valeurs des variables $KPI(N_i)$, ...,$KPI(N_m)$ de l'indicateur de qualité pour déterminer une fonction empirique représentative de la loi probabiliste de fiabilité $P(n)$ en fonction de la quantité de données d'observation 7.

En outre, à l'étape E4 les moyens d'analyse 12 sont configurés pour estimer à partir de la loi probabiliste de fiabilité $P(n)$ une quantité minimale $N_0$ (i.e. un nombre minimal) de données d'observation à partir de laquelle la valeur de l'indicateur de qualité $KPI(n)_{n \geq N_0}$ atteint un critère de fiabilité prédéterminé avec une probabilité $P(KPI(n)_{n \geq N_0} \in I)$ supérieure à une valeur prédéterminée $1 - \varepsilon$, la valeur prédéterminée $1 - \varepsilon$ étant le complémentaire d'une erreur acceptable $\varepsilon$. Autrement dit, les moyens d'analyse 12 recherchent le premier $N_0$ tel que $P(KPI(N_0) \in I) > 1 - \varepsilon$.

Par exemple, pour le taux de détection POD, on recherche le premier $N_0$ qui vérifie la relation suivante :

$$P(POD(N_0) > 1 - \beta) > 1 - \varepsilon$$

Par ailleurs, pour le taux de fausse alarme PFA, on recherche le premier $N_0$ qui vérifie la relation suivante :

$$P(PFA(N_0) < \alpha) > 1 - \varepsilon$$

$1 - \beta$ et a représentent les exigences de fiabilité relatives au POD et PFA respectivement.

Afin d'estimer la quantité minimale $N_0$, les moyens d'analyse 12 sont avantageusement configurés pour construire une courbe de la loi probabiliste de fiabilité $P(n)$ pour $n = N_i, ...., N_m$. Cette courbe est ensuite extrapolée jusqu'à ce qu'elle croise l'axe des ordonnées à la valeur prédéterminée $1 - \varepsilon$. Cela donnera en abscisse une estimation du nombre minimal $N_0$ recherché de données d'observation 7.

En variante, afin de déterminer le premier $N_0$ permettant d'atteindre l'objectif, on peut construire une courbe de l'erreur $\varepsilon(n)$ représentant le complémentaire $1 - P(n)$ de la loi $P(n)$ et extrapoler la courbe jusqu'à ce qu'elle croise l'axe des ordonnées à la valeur de l'erreur acceptable $\varepsilon$.

On notera que pour le taux de fausse alarme PFA, la loi probabiliste de fiabilité $P(n)$ est une moyenne de $n$ expériences booléennes de paramètre $p$ représentant la vraie valeur du PFA. Sa loi est donc celle d'une Binomiale divisée par n, elle converge vers une loi normale de moyenne $p$ et de variance $\sigma_n = p(1 - p)/n$ de la forme suivante :

$$P(n) = \frac{1}{\sqrt{2\pi}} \int_{-\infty}^{(\alpha-p)/\sigma_n} e^{-\frac{x^2}{2}} dx = \frac{1}{2}\left(1 + erf\frac{\alpha - p}{\sqrt{2}\,\sigma_n}\right)$$

Avantageusement, pour simplifier la méthode d'estimation de la loi théorique $P(n)$, on utilise des hypothèses sur l'évolution de cette loi. Par exemple, quand $\alpha$ est inférieur à p, la loi théorique $P(n)$ converge exponentiellement vers zéro.

Ainsi, pour le taux de fausse alarme PFA, la loi théorique de fiabilité $P(n)$ peut être représentée par une fonction d'approximation $f(n)$ de la forme suivante :

$$f(n) = a + \frac{b}{\sqrt{n}} + c\log(n)$$

où $a, b, c$ sont des constantes pouvant être déterminées par une technique de régression sur l'ensemble de valeurs $PFA(N_i), ..., PFA(N_m)$ du taux de fausse alarme PFA. On notera que le terme en $\log(n)$ sert à corriger la décroissance en $\frac{1}{\sqrt{n}}$ de la fonction d'approximation $f(n)$ réduisant ainsi l'erreur d'approximation et permettant d'avoir une estimation plus conforme à la loi théorique $P(n)$.

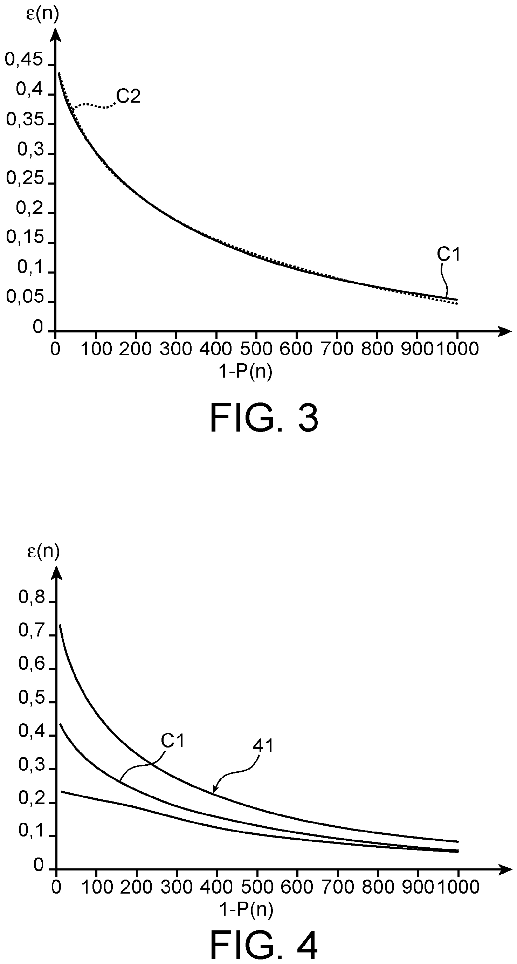

La Fig. 3 est un graphique représentant les courbes de l'erreur $\varepsilon(n)$ relative à la loi théorique de fiabilité $P(n)$ relative au PFA et à sa fonction d'approximation $f(n)$ correspondante.

La courbe théorique C1 donne l'allure de $\varepsilon(n) = 1 - P(n)$ pour un paramètre $p = 4\%$ et une exigence de fiabilité $\alpha = 5\%$ et la courbe en pointillée C2 représente l'approximation $1 - f(n)$. Les deux courbes C1 et C2 sont quasiment identiques et par conséquent, on peut utiliser le complémentaire de la fonction d'approximation $f(n)$ pour déterminer la quantité minimale de données d'observation.

A titre d'exemple, si on cherche une précision de 0.9 (i.e., une erreur $\varepsilon(n) = 0.1$) avec un taux de fausse alarme théorique de $p = 4\%$ et une exigence de a = 5%, il faut au moins 650 mesures comme indiqué sur le graphique. Autrement dit, pour évaluer une validation de surveillance d'un équipement du moteur 5 d'aéronef avec un taux de fausse alarme inférieur à 5% et une probabilité ou une assurance de 90%, il faut collecter environ 650 données d'observation.

Par ailleurs, la précision sur les données d'observation augmente avec l'augmentation du nombre de données.

En effet, la Fig. 4 est un graphique représentant des mesures d'observation autour de la courbe représentative de l'erreur $\varepsilon(n)$. Ces mesures forment un tube de confiance 41 autour de la courbe C1 ou C2 montrant que la précision est faible au début des expériences, puis le tube s'affine au fur à mesure que le nombre de données augmente.

Finalement, à l'étape E5, les moyens de test 13 appliquent des indicateurs de qualité KPI sur le nombre minimal $N_0$ de données d'observation afin d'évaluer de manière optimale la validation du système de surveillance 3.

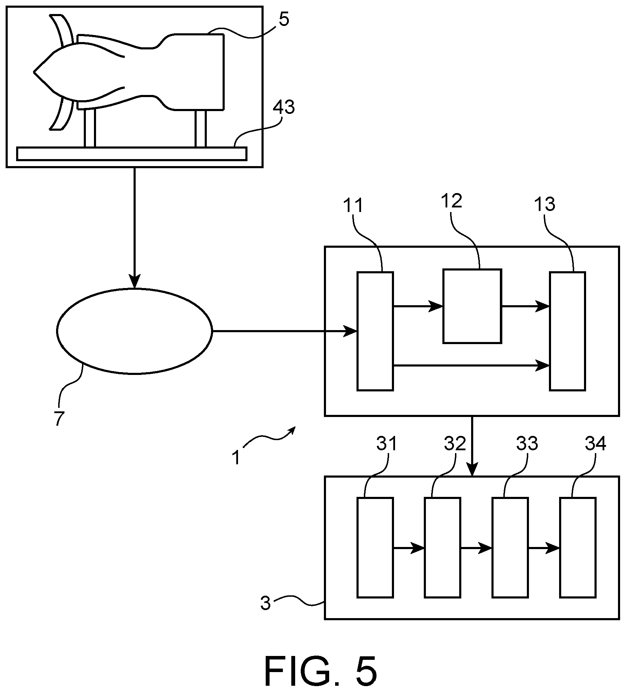

La Fig. 5 illustre de manière schématique un outil de validation d'un système de surveillance d'un équipement d'un moteur d'aéronef, selon un premier mode de réalisation préféré de l'invention.

Ce premier mode de réalisation concerne la validation d'un système de surveillance 3 générique sur un banc d'essai 43 avant son installation sur un aéronef.

En effet, le cahier des charges du système de surveillance 3 se dérive en spécifications de besoins, elles même s'exprimant en exigences et objectifs. On répond à une exigence ou un objectif quand on dispose d'un test permettant de valider les performances attendues. Ce test s'applique sur au moins une partie de l'ensemble d'indicateurs de qualité KPI que l'on compare à des seuils définis par les spécifications. Les KPI sont calculés par des scénarios de validations adaptés aux problèmes soulevés par l'exigence ou l'objectif. Les scénarios s'appuient sur des données d'observation assurant une couverture raisonnable du besoin.

Ainsi, les moyens de traitement 11 recueillent des données d'observation 7 relatives à l'équipement à surveiller et réalisées sur le banc d'essai 43. En variante, les données d'observation 7 sont recueillies sur des aéronefs testant le système de surveillance 3.

Tel que précédemment décrit, les moyens d'analyse 12 calculent la valeur de chaque indicateur de qualité sur une quantité courante de données d'observation 7. Ensuite, ils estiment un nombre minimal de données d'observation à partir duquel la valeur de l'indicateur de qualité vérifie un critère de fiabilité prédéterminé avec une probabilité supérieure à une valeur prédéterminée. Ce nombre minimal de données d'observation garantit une couverture suffisante pour que les indicateurs de qualité aient un sens et permet par conséquent, de savoir à partir de quand, on peut arrêter de faire des essais sur le banc 43.

Les moyens de test 13 évaluent ensuite la validation du système de surveillance 3 en appliquant des indicateurs de qualité KPI sur le nombre minimal de données d'observation 7 relatives à cet équipement.

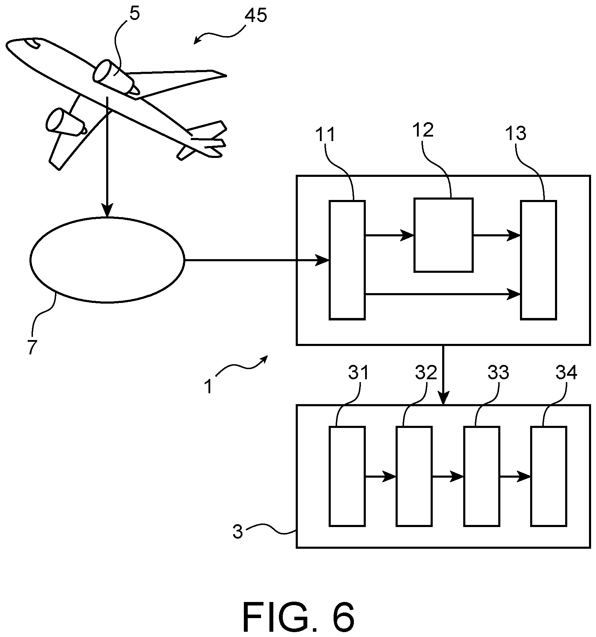

La Fig. 6 illustre de manière schématique un outil de validation d'un système de surveillance d'un équipement d'un moteur d'aéronef, selon un deuxième mode de réalisation préféré de l'invention.

Ce deuxième mode de réalisation concerne la validation et le réglage d'un système de surveillance 3 après son installation sur un moteur 5 de série d'un aéronef 45 en appliquant au moins une partie de l'ensemble d'indicateurs de qualité sur la quantité minimale de données d'observation recueillies en vol.

Le système de surveillance 3 est déjà pré-étalonné sur un jeu de mesures d'observation faites sur un banc d'essai 41 selon le premier mode de réalisation ou sur des aéronefs appartenant à des compagnies acceptant de contribuer dans le développement des systèmes de surveillances.

On notera que l'aéronef 43 sur lequel est embarqué le système de surveillance 3 va suivre des missions qui lui sont propres, il aura aussi droit à des opérations de maintenance spécifiques à la logique de la compagnie propriétaire. Ainsi, la validation prend en compte la spécificité de l'utilisation du moteur sur lequel il est installé.

Tel que précédemment exposé, les moyens de traitement 12 recueillent des données d'observation 7 relatives à l'équipement à surveiller réalisées sur le moteur en opération. Les moyens d'analyse 12 estiment un nombre minimal de données d'observation à partir duquel la valeur d'un indicateur de qualité atteint un critère de fiabilité prédéterminé avec une probabilité supérieure à une valeur prédéterminée. Ceci permet de connaître à partir de quand on peut arrêter le test de validation, mais aussi quand le reprendre si les opérations effectuées par l'aéronef porteur changent ou si la configuration du moteur évolue à la suite d'opérations de maintenance.

## Revendications

1. Outil de validation d'un système de surveillance (3) d'au moins un équipement d'un moteur (5) d'aéronef, comprenant des moyens de test (13) configurés pour évaluer une validation dudit système de surveillance (1) en appliquant un ensemble d'indicateurs de qualité sur un volume de données d'observation (7) relatives audit équipement, qui comporte:

   - des moyens de traitement (11) configurés pour recueillir des données d'observation relatives audit équipement,
   - des moyens d'analyse (12) configurés pour calculer une valeur courante d'au moins un indicateur de qualité sur une quantité courante de données d'observation recueillies par les moyens de traitement (11), **caractérisé**

**en ce qu'**il comporte:

- des moyens d'analyse (12) configurés pour estimer la probabilité que ladite valeur courante de l'indicateur de qualité atteigne un critère de fiabilité prédéterminé, formant ainsi une loi probabiliste de fiabilité estimée sur un ensemble de valeurs de l'indicateur de qualité relatif à un ensemble correspondant de quantités de données d'observation, et

- des moyens d'analyse (12) configurés pour estimer à partir de ladite loi probabiliste de fiabilité une quantité minimale de données d'observation à partir de laquelle la valeur de l'indicateur de qualité atteint un critère de fiabilité prédéterminé avec une probabilité supérieure à une valeur prédéterminée, ladite quantité minimale de données d'observation correspondant audit volume de données d'observation destiné à être utilisé pour évaluer la validation dudit système de surveillance.

2. Outil de validation selon la revendication 1, **caractérisé en ce que** ladite valeur prédéterminée est le complémentaire d'une erreur prédéfinie comme étant acceptable.

3. Outil de validation selon la revendication 1 ou 2, **caractérisé en ce que** les moyens d'analyse (12) sont configurés pour calculer la valeur courante d'un indicateur de qualité en appliquant une technique de validation croisée sur ladite quantité courante de données d'observation.

4. Outil de validation selon la revendication 3, **caractérisé en ce que** ladite technique de validation croisée est sélectionnée parmi les techniques suivantes : bootstrap, K-fold, leave-one-out.

5. Outil de validation selon l'une quelconque des revendications précédentes, **caractérisé en ce que** l'ensemble d'indicateurs de qualité comporte les indicateurs suivants : taux de fausse alarme, taux de détection, taux de localisation.

6. Outil de validation selon l'une quelconque des revendications précédentes, **caractérisé en ce que** les moyens d'analyse (12) sont configurés pour appliquer une technique de régression sur ledit ensemble de valeurs de l'indicateur de qualité pour déterminer une fonction d'approximation représentative de ladite loi probabiliste de fiabilité en fonction de la quantité de données d'observation.

7. Outil de validation selon la revendication 6, **caractérisé en ce que** pour un indicateur de qualité correspondant aux taux de fausse alarme, ladite fonction d'approximation en fonction de la quantité n de données d'observation est exprimée par la relation suivante :

$$f(n) = a + \frac{b}{\sqrt{n}} + c\log(n)$$

où *a, b, c* sont des constantes de régression.

8. Outil de validation selon l'une quelconque des revendications précédentes, **caractérisé en ce que** les moyens de test sont configurés pour évaluer une validation dudit système de surveillance avant son installation sur un aéronef en appliquant l'ensemble d'indicateurs de qualité sur une quantité de données d'observation recueillies sur un banc d'essai et/ou sur une flotte de moteurs d'aéronefs en opération.

9. Outil de validation selon la revendication 8, **caractérisé en ce que** les moyens de test (13) sont configurés pour poursuivre la validation et le réglage dudit système de surveillance après son installation sur un moteur (5) de série en appliquant l'ensemble d'indicateurs de qualité sur une quantité de données d'observation recueillies en vol.

10. Système de surveillance d'au moins un équipement d'un moteur d'aéronef conçu par l'outil de validation selon l'une quelconque des revendications précédentes, **caractérisé en ce qu'**il est configuré pour recevoir des données d'observation spécifiques audit équipement et pour délivrer un résultat diagnostiquant l'état dudit équipement.

11. Procédé de validation d'un système de surveillance d'au moins un équipement d'un moteur d'aéronef, comprenant des étapes de test pour évaluer une validation dudit système de surveillance en appliquant un ensemble d'indicateurs de qualité sur un volume de données d'observation relatives audit équipement, **caractérisé en ce qu'**il comporte en outre les étapes suivantes :

- recueillir des données d'observation relatives audit équipement,
- calculer une valeur courante d'au moins un indicateur de qualité sur une quantité courante de données d'observation recueillies par les moyens de traitement,
- estimer la probabilité que ladite valeur courante de l'indicateur de qualité atteigne un critère de fiabilité prédéterminé, formant ainsi une loi probabiliste de fiabilité estimée sur un ensemble de valeurs de l'indicateur de qualité relatif à un ensemble correspondant de quantités de données d'observation, et
- estimer à partir de ladite loi probabiliste de fiabilité une quantité minimale de données d'observation à partir de laquelle la valeur de l'indicateur de qualité atteint un critère de fiabilité prédéterminé avec une probabilité supérieure à une valeur prédéterminée, ladite quantité minimale de données d'observation correspondant audit volume de données d'observation destiné à être utilisé pour évaluer la validation dudit système de surveillance.

**Patentansprüche**

1. Werkzeug zur Validierung eines Überwachungssystems (3) zur Überwachung wenigstens eines Ausrüstungselements eines Luftfahrzeug-Triebwerks (5), welches Testmittel (13) umfasst, die konfiguriert sind, um eine Validierung dieses Überwachungssystems (3) durch Anwenden eines Satzes von Qualitätsindikatoren auf eine Beobachtungsdatenmenge (7) bezüglich des genannten Ausrüstungselements zu bewerten, und welches umfasst:

   - Bearbeitungsmittel (11), die konfiguriert sind, um Beobachtungsdaten bezüglich des genannten Ausrüstungselements zu zu sammeln,
   - Analysemittel (12), die konfiguriert sind, um einen momentanen Wert mindestens eines Qualitätsindikators auf eine momentane Menge von Beobachtungsdaten, die von den Bearbeitungsmitteln (11) gesammelt wurden, zu berechnen,

   **dadurch gekennzeichnet,**
   **dass** es umfasst:

   - Analysemittel (12), die konfiguriert sind, um die Wahrscheinlichkeit zu schätzen, dass der genannte momentane Wert des Qualitätsindikators ein voraus bestimmtes Verlässlichkeitskriterium erreicht, wobei auf diese Weise eine geschätzte Wahrscheinlichkeitsregel der Verlässlichkeit auf einen Satz von Werten des Qualitätsindikators bezogen auf einen entsprechenden Satz von Beobachtungsdatenmengen gebildet wird, sowie
   - Analysemittel (12), die konfiguriert sind, um auf Basis dieser Verlässlichkeits-Wahrscheinlichkeitsregel eine Minimalmenge an Beobachtungsdaten zu schätzen, von der ab der Wert des Qualitätsindikators ein voraus bestimmtes Verlässlichkeitskriterium mit einer Wahrscheinlichkeit erreicht, die größer ist als ein voraus festgelegter Wert, wobei die genannte Minimalmenge an Beobachtungsdaten der Beobachtungsdatenmenge entspricht, die dazu verwendet werden soll, die Validierung des genannten Überwachungssystems zu bewerten.

2. Werkzeug zur Validierung nach Anspruch 1,

   **dadurch gekennzeichnet,**
   **dass** der genannte voraus festgelegte Wert das Komplementär eines als hinnehmbar vordefinierten Fehlers ist.

3. Werkzeug zur Validierung nach Anspruch 1 oder 2,

   **dadurch gekennzeichnet,**
   **dass** die Analysemittel (12) konfiguriert sind, um den momentanen Wert eines Qualitätsindikators unter Anwendung einer Kreuzvalidierungstechnik auf die genannte momentane Menge von Beobachtungsdaten zu berechnen.

4. Werkzeug zur Validierung nach Anspruch 3,

   **dadurch gekennzeichnet,**
   **dass** die genannte Kreuzvalidierungstechnik aus folgenden Methoden ausgewählt wird: bootstrap, K-fold, leave-one-out.

5. Werkzeug zur Validierung nach einem der vorherigen Ansprüche,

**dadurch gekennzeichnet,**
**dass** der Satz von Qualitätsindikatoren die folgenden Indikatoren umfasst: Fehlalarmrate, Erkennungsrate, Lokalisierungsrate.

6. Werkzeug zur Validierung nach einem der vorherigen Ansprüche,

**dadurch gekennzeichnet,**
**dass** die Analysemittel (12) konfiguriert sind, um eine Regressionstechnik auf den genannten Satz von Qualitätsindikatoren anzuwenden, um eine Näherungsfunktion entsprechend der genannten Verlässlichkeits-Wahrscheinlichkeitsregel in Abhängigkeit von der Beobachtungsdatenmenge zu bestimmen.

7. Werkzeug zur Validierung nach Anspruch 6,

**dadurch gekennzeichnet,**
**dass** für einen Qualitätsindikator, der der Fehlalarmrate entspricht, die genannte Näherungsfunktion in Abhängigkeit von der Menge n von Beobachtungsdaten durch folgende Relation ausgedrückt wird:

$$f(n) = a + \frac{b}{\sqrt{n}} + c \log(n)$$

wobei a, b, c Regressionskonstanten sind.

8. Werkzeug zur Validierung nach einem der vorherigen Ansprüche,

**dadurch gekennzeichnet,**
**dass** die Testmittel konfiguriert sind, um eine Validierung des genannten Überwachungssystems vor dessen Einbau in ein Luftfahrzeug zu bewerten, indem der Satz von Qualitätsindikatoren auf eine Menge von Beobachtungsdaten angewendet wird, die in einem Versuchsstand und/oder aus einer in Betrieb befindlichen Luftfahrzeug-Triebwerksflotte gesammelt wurden.

9. Werkzeug zur Validierung nach Anspruch 8,

**dadurch gekennzeichnet,**
**dass** die Testmittel konfiguriert sind, um die Validierung und die Regelung des genannten Überwachungssystems nach dessen Einbau in ein Serientriebwerk (5) durchzuführen, indem der Satz von Qualitätsindikatoren auf eine Menge von Beobachtungsdaten angewendet wird, die während des Flugbetriebs gesammelt wurden.

10. Überwachungssystem für wenigstens ein Ausrüstungselement eines Luftfahrzeug-Triebwerks, welches durch das Werkzeug zur Validierung nach einem der vorherigen Ansprüche konzipiert ist,

**dadurch gekennzeichnet,**
**dass** es konfiguriert ist, um spezifische Beobachtungsdaten des genannten Ausrüstungselements zu empfangen und um ein Ergebnis zu liefern, das den Zustand dieses Ausrüstungselements diagnostiziert.

11. Verfahren zur Validierung eines Überwachungssystems für wenigstens ein Ausrüstungselement eines Luftfahrzeug-Triebwerks, welches Test-Verfahrensschritte zur Bewertung einer Validierung des genannten Überwachungssystems durch Anwendung eines Satzes von Qualitätsindikatoren auf eine Menge von Beobachtungsdaten bezüglich des genannten Ausrüstungselements umfasst,

**dadurch gekennzeichnet,**
**dass** es ferner folgende Verfahrensschritte umfasst:

- Sammeln von Beobachtungsdaten bezüglich des genannten Ausrüstungselements,
- Berechnen eines momentanen Werts mindestens eines Qualitätsindikators auf eine momentane Menge von Beobachtungsdaten, die von den Bearbeitungsmitteln gesammelt wurden,
- Schätzen der Wahrscheinlichkeit, dass der genannte momentane Wert des Qualitätsindikators ein voraus bestimmtes Verlässlichkeitskriterium erreicht, wobei auf diese Weise eine geschätzte Wahrscheinlichkeitsregel der Verlässlichkeit auf einen Satz von Werten des Qualitätsindikators bezogen auf einen entsprechenden Satz von Beobachtungsdatenmengen gebildet wird, sowie

- Schätzen auf Basis dieser Verlässlichkeits-Wahrscheinlichkeitsregel einer Minimalmenge an Beobachtungsdaten, von der ab der Wert des Qualitätsindikators ein voraus bestimmtes Verlässlichkeitskriterium mit einer Wahrscheinlichkeit erreicht, die größer ist als ein voraus festgelegter Wert, wobei die genannte Minimalmenge an Beobachtungsdaten der Beobachtungsdatenmenge entspricht, die dazu verwendet werden soll, die Validierung des genannten Überwachungssystems zu bewerten.

## Claims

1. Tool for validation of a system (3) for monitoring at least one item of equipment on an aircraft engine (5), comprising test means (13) configured to evaluate a validation of said monitoring system (1) by applying a set of quality indicators to a volume of observation data (7) related to said equipment, that comprises:

   - processing means (11) configured to collect observation data related to said equipment,
   - analysis means (12) configured to calculate a current value of at least one quality indicator on a current quantity of observation data collected by the processing means (11), **characterised in that** it comprises:

     - analysis means (12) configured to estimate the probability that said current value of the quality indicator reaches a predetermined reliability criterion, thus forming a probabilistic reliability law estimated on a set of values of the quality indicator applicable to a corresponding set of quantities of observation data, and
     - analysis means (12) configured to estimate a minimum quantity of observation data from said probabilistic reliability law, starting from which the value of the quality indicator reaches a predetermined reliability criterion with a probability exceeding a predetermined value, said minimum quantity of observation data corresponding to said volume of observation data that will be used to evaluate the validation of said monitoring equipment.

2. Validation tool according to claim 1, **characterised in that** said predetermined value is the complement of an error predefined as being acceptable.

3. Validation tool according to claim 1 o 2, **characterised in that** the analysis means (12) are configured to calculate the current value of a quality indicator by applying a cross-validation technique on said current quantity of observation data.

4. Validation tool according to claim 3, **characterised in that** said cross validation technique is selected from among the following techniques: bootstrap, K-fold, leave-one-out.

5. Validation tool according to any one of the previous claims, **characterised in that** the set of quality indicators includes the following indicators: false alarm ratio, detection ratio, localisation ratio.

6. Validation tool according to any one of the previous claims, **characterised in that** the analysis means (12) are configured to apply a regression technique on said set of quality indicator values to determine an approximation function representative of said probabilistic reliability law as a function of the quantity of observation data.

7. Validation tool according to claim 6, **characterised in that**, for a quality indicator corresponding to the probability of false alarm, said approximation function as a function of the quantity n of observation data is expressed by the following relation:

$$f(n) = a + \frac{b}{\sqrt{n}} + c \log(n)$$

   in which *a, b, c* are regression constants.

8. Validation tool according to any one of the previous claims, **characterised in that** the test means are configured to evaluate a validation of said monitoring system before its installation on an aircraft by applying the set of quality indicators on a quantity of observation data collected on a test bench and/or a fleet of aircraft engines in operation.

9.  Validation tool according to claim 8, **characterised in that** the test means (13) are configured to continue validation and adjustment of said monitoring system after its installation on a series engine (5) by applying the set of quality indicators on a quantity of observation data collected in flight.

10. System for monitoring at least one item of equipment on an aircraft engine designed by the validation tool according to any one of the previous claims, **characterised in that** it is configured to receive observation data specific to said equipment and to deliver a result containing a diagnostic of the state of said equipment.

11. Method of validating a system for monitoring at least one item of aircraft engine equipment, comprising test steps to evaluate a validation of said monitoring system by applying a set of quality indicators to a volume of observation data related to said equipment, **characterised in that** it also comprises the following steps:

- collect observation data related to said equipment,
- calculate a current value of at least one quality indicator on a current quantity of observation data collected by the processing means,
- estimate the probability that said current value of the quality indicator reaches a predetermined reliability criterion, thus forming a probabilistic reliability law estimated on a set of values of the quality indicator applicable to a corresponding set of quantities of observation data, and
- estimate a minimum quantity of observation data from said probabilistic reliability law, starting from which the value of the quality indicator reaches a predetermined reliability criterion with a probability exceeding a predetermined value, said minimum quantity of observation data corresponding to said volume of observation data that will be used to evaluate the validation of said monitoring equipment.

FIG. 1

$$n \quad \boxed{\phantom{xx}} \quad E1$$

FIG. 2

FIG. 3

FIG. 4

FIG. 5

FIG. 6

**EP 3 215 903 B1**

**RÉFÉRENCES CITÉES DANS LA DESCRIPTION**

**Documents brevets cités dans la description**

- FR 2957170